(19) Europäisches Patentamt
European Patent Office
Office européen des brevets

(11) **EP 4 517 839 A1**

(12) **EUROPEAN PATENT APPLICATION**
published in accordance with Art. 153(4) EPC

(43) Date of publication:
**05.03.2025 Bulletin 2025/10**

(21) Application number: **23887530.6**

(22) Date of filing: **24.07.2023**

(51) International Patent Classification (IPC):
***H01L 31/101*** (2006.01)    ***H01L 31/0232*** (2014.01)
***G01S 17/08*** (2006.01)

(52) Cooperative Patent Classification (CPC):
Y02P 70/50

(86) International application number:
**PCT/CN2023/108864**

(87) International publication number:
**WO 2024/098834 (16.05.2024 Gazette 2024/20)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **10.11.2022 CN 202211407177**

(71) Applicant: **Phograin Technology (Shenzhen) Co.,
Ltd.
Shenzhen, Guangdong 518000 (CN)**

(72) Inventors:
• **YANG, Yanwei**
**Shenzhen, Guangdong 518055 (CN)**
• **LIU, Hongliang**
**Shenzhen, Guangdong 518055 (CN)**
• **LU, Yifeng**
**Shenzhen, Guangdong 518055 (CN)**
• **ZOU, Yan**
**Shenzhen, Guangdong 518055 (CN)**

(74) Representative: **Taor, Simon Edward William et al
Venner Shipley LLP
200 Aldersgate
London EC1A 4HD (GB)**

(54) **PHOTOELECTRIC DETECTOR CHIP, DISTANCE SENSOR AND ELECTRONIC APPARATUS**

(57)    Provided are a photodetector chip, a proximity sensor, and an electronic device. The photodetector chip includes a first electrode, a substrate, a light absorption layer, a top layer, a second electrode, and a filter layer. The substrate is disposed on one side of the first electrode. The light absorption layer is disposed at one side of the substrate away from the first electrode. The top layer is disposed at one side of the light absorption layer away from the substrate. The second electrode is in contact with the top layer, and the second electrode is disposed at one side of the top layer away from the light absorption layer. The filter layer is disposed at one side of the light absorption layer away from the substrate and is located on one side of the second electrode adjacent to the top layer. The filter layer is configured to filter out a signal having a wavelength less than 1300 nm and allow a detection signal having a wavelength greater than or equal to 1300 nm to pass through to the light absorption layer.

FIG. 5

EP 4 517 839 A1

**Description**

CROSS-REFERENCE TO RELATED APPLICATION(S)

The present application claims the right of priority of application no. 202211407177.4 filed on 10 November 2022 and entitled "OPTOELECTRONIC DETECTOR CHIP, PROXIMITY SENSOR, AND ELECTRONIC DEVICE", the contents of the described earlier application are incorporated herein by reference.

TECHNICAL FIELD

The present application relates to the field of chip technologies, and in particular, to a photodetector chip, a proximity sensor, and an electronic device.

BACKGROUND

With the development of technology, electronic devices with a photoelectric detection function have been applied more and more widely. The electronic device generally has a photodetector chip to implement a photoelectric detection function. For example, a proximity sensor in the electronic device includes a photodetector chip to implement distance sensing. An electronic device (for example, a mobile phone) generally includes a liquid crystal display screen and a proximity sensor. The proximity sensor is disposed below the liquid crystal display screen, and the proximity sensor generally includes a silicon-based photodetector chip, so as to receive a detection signal reflected back. However, a photodetector chip in the related art is less accurate in detecting a distance when applied in a proximity sensor.

SUMMARY

According to a first aspect, embodiments of the present application provides a photodetector chip. The photodetector chip includes a first electrode, a substrate, a light absorption layer, a top layer, a second electrode, and a filter layer.
The substrate is disposed on one side of the first electrode. The light absorption layer is disposed at one side of the substrate away from the first electrode. The top layer is disposed at one side of the light absorption layer away from the substrate. The second electrode is in contact with the top layer and is disposed on one side of the top layer away from the light absorption layer. The filter layer is disposed at one side of the light absorption layer away from the substrate and on one side of the second electrode adjacent to the top layer. The filter layer is configured to filter a signal having a wavelength less than 1300 nm, and allow a detection signal having a wavelength greater than or equal to 1300 nm to pass through to the light absorption layer.
According to a second aspect, the present application provides a proximity sensor. The proximity sensor includes a transmission chip configured to transmit a detection signal and the photodetector chip according to the first aspect. The filter layer in the photodetector chip is configured to filter out a signal having a wavelength less than 1300 nm and allow a detection signal having a wavelength greater than or equal to 1300 nm to pass through.
According to a third aspect, the present application provides an electronic device. The electronic device includes a display screen having a display region, the proximity sensor according to the second aspect. The proximity sensor is disposed at one side of the display screen and corresponds to a display region of the display screen. The transmission chip of the proximity sensor is configured to transmit a detection signal towards the display screen, and the photodetector chip of the proximity sensor is configured to receive the detection signal passing through the display screen. The wavelength of the detection signal is greater than or equal to 1300 nm.
In the present embodiment, the photodetector chip is provided with a filter layer, and the filter layer is disposed at side of the light absorption layer away from the substrate, and is located at one side of the second electrode adjacent to the top layer. The filter layer is configured to filter out a signal having a wavelength less than 1300 nm (for example, a visible light having a wavelength less than 750 nm), so that less light having a wavelength less than 1300 nm or even no light having a wavelength less than 1300 nm enters the light absorption layer. Therefore, the light absorption layer in the photodetector chip provided in this embodiment can achieve a less responsivity to light having a wavelength less than 1300 nm (for example, the visible light having a wavelength less than 750 nm), such as less than 0.02 A/W. When the photodetector chip is applied to a proximity sensor, the distance detection is more accurate.

BRIEF DESCRIPTION OF THE DRAWINGS

To describe the technical solutions in the embodiments of the present application more clearly, the following briefly introduces the accompanying drawings required for describing the embodiments. Apparently, the accompanying drawings in the following description show merely some embodiments of the present application, and a person of ordinary skill in the art may still derive other drawings from these accompanying drawings without creative efforts.

    Fig. 1 illustrates the responsivity of InGaAs and Si-based material to various wavelengths.
    Fig. 2 is a top view of a photodetector chip provided in an embodiment in the related art.
    Fig. 3 is a cross-sectional view of the photodetector chip in Fig. 2 along line A-A.
    Fig. 4 is a top view of a photodetector chip provided in an embodiment of the present application.

Fig. 5 is a schematic cross-sectional view of the photodetector chip in Fig. 4 along line B-B in an embodiment.

Fig. 6 is a schematic cross-sectional view of the photodetector chip in Fig. 4 along line B-B in another embodiment.

Fig. 7 is a schematic diagram of an active region of the photodetector chip shown in Fig. 5.

Fig. 8 is a schematic diagram of an active region of the photodetector chip shown in Fig. 6.

Fig. 9 is a top view of a photodetector chip provided in another embodiment of the present application.

Fig. 10 is a top view of a photodetector chip provided in still another embodiment of the present application.

Fig. 11 is a schematic diagram of a proximity sensor provided in an embodiment of the present application.

Fig. 12 is a schematic diagram of an electronic device provided in an embodiment of this application.

FIG 13 is a cross-sectional view along line C-C in FIG. 12.

DETAILED DESCRIPTION

The following clearly and completely describes the technical solutions in the embodiments of the present application with reference to the accompanying drawings in the embodiments of the present application. Apparently, the described embodiments are merely a part rather than all of the embodiments of the present application. All other embodiments obtained by a person of ordinary skill in the art based on the embodiments of the present application without creative efforts shall belong to the scope of protection of the present application.

The terms "first", "second", and the like in the description and claims of the present application and the accompanying drawings are used for distinguishing different objects, rather than for describing a specific order. Furthermore, the terms "include" and "have" and any variations thereof are intended to cover exclusive inclusions. For example, a process, method, system, product or apparatus that includes a series of steps or units is not limited to the listed steps or units, but optionally further includes the steps or units not listed, or optionally further includes other steps or units inherent to the process, method, product or apparatus.

Reference herein to "an embodiment" or "an implementation" means that a particular feature, structure, or characteristic described in connection with the embodiment or embodiment can be included in at least one embodiment of the present disclosure. The appearances of this phrase in various places in the description are not necessarily all referring to the same embodiment, nor are separate or alternative embodiments mutually exclusive of other embodiments. It is apparent and implicitly understood by those skilled in the art that the embodiments described herein can be combined with other embodiments.

With the development of technology, an electronic device 1 with a photoelectric detection function has been applied more and more widely. The electronic device 1 generally includes a photodetector chip 100 to implement the photoelectric detection function. For example, a proximity sensor 10 in the electronic device 1 includes a photodetector chip 100 (Si PD) to implement distance sensing. Currently, the electronic device 1 (such as a mobile phone or a tablet computer) generally includes a liquid crystal display screen 30 and a proximity sensor 10. The proximity sensor 10 is disposed under the liquid crystal display screen 30, and the proximity sensor 10 usually includes a silicon-based photodetector chip so as to receive a detection signal reflected back. Specifically, the detection signal (typically infrared light of 940 nm) can pass through the liquid crystal display panel 30 and be received by the photodetector chip 100.

For the electronic device 1 including the OLED display screen 30, the transmittance of the infrared light having a wavelength of 940 nm, that can be received by the silicon-based photodetector chip, is very low in the OLED display screen 30, and therefore, the silicon-based photodetector chip cannot be placed below the OLED display screen 30. When the silicon-based photodetector chip is applied to the electronic device 1 including the OLED display screen 30, it is generally necessary to have holes on the display screen 30 and as a result, a full-screen of the electronic device 1 cannot be achieved.

Light having a wavelength greater than 1300 nm (e. g., 1310 nm) may pass through the OLED display panel 30 and have a high transmittance. In order to implement a full-screen of the electronic device 1 including the OLED display panel 30, light having a wavelength greater than 1300 nm (e. g., 1310 nm) is generally used as a detection signal. However, a maximum wavelength that can be received by a silicon-based photodetector chip is 1064 nm. Therefore, in the related art (not in the prior art), the photodetector chip 100 of InGaAs material (InGaAs photodetector chip 100, InGaAs PD) is used as a photosensitive element of the proximity sensor 10 (P-Sensor), so as to receive a detection signal having a wavelength greater than 1300 nm (for example, 1310 nm).

Considering the actual application of the proximity sensor 10 in the electronic device 1, the application of the InGaAs photodetector chip 100 in the proximity sensor 10 needs to fulfill two main functions: (1) has no effect on light (visible light) having a wavelength less than or equal to 1300 nm (for example, 750 nm), or substantially has no response (for example, a responsivity less than 0.02 A/W), so as to avoid interference of ambient light (visible light) around the electronic device 1 on the proximity sensor 10; (2) has a relatively high responsivity to light having a wavelength greater than or equal to 1300 nm, such as 1310 nm.

Due to the properties of InGaAs materials, the InGaAs material have a relatively high responsivity to light having a wavelength greater than 1300 nm, such as 1310 nm. However, the InGaAs material will absorb light having a wavelength less than or equal to 750 nm, and the InGaAs photodetector chip 100 in the related art generally has a responsivity of 0.1 A/W to the light having a wavelength less than or equal to 750 nm, and the requirement of a responsivity being less than 0.02 A/W cannot be satisfied.

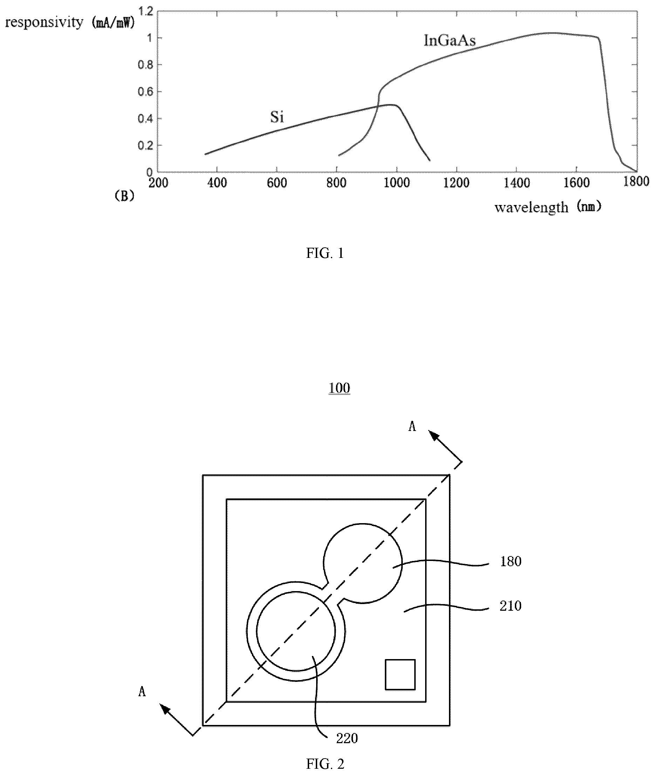

Please refer to Fig. 1, Fig. 1 illustrates the responsivity of InGaAs and Si-based material to various wavelengths. In Fig. 1, the horizontal axis represents the wavelength in nm; the vertical axis represents the responsivity, also called response rate or Response, in mA/mW. In the figure, Si represents the responsivity of the Si-based material to various wavelengths, and In-GaAs represents the responsivity of InGaAs to various wavelengths. It can be seen therefrom that the InGaAs material has a large responsivity to light having a wavelength less than 750 nm, and specifically, the InGaAs material generally has a responsivity of about 0.1 A/W to light having a wavelength less than or equal to 750 nm, as a result, the requirement of a responsivity being less than 0.02 A/W cannot be satisfied.

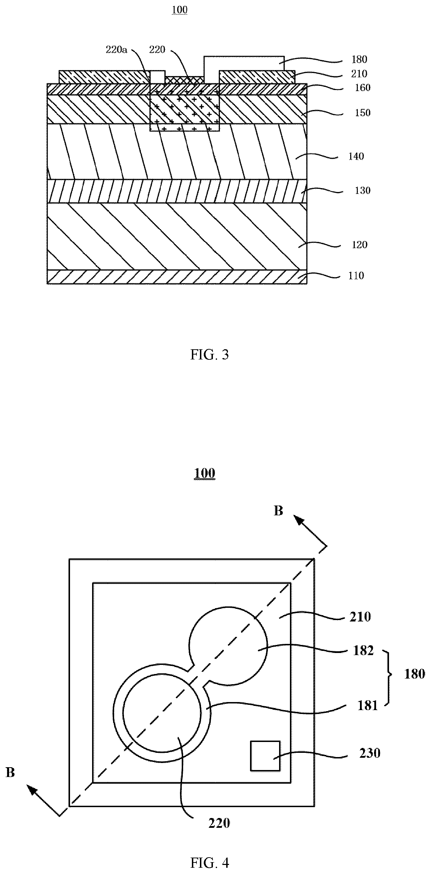

The InGaAs photodetector chip 100 in the related art (not the related art) will be introduced below. In order to facilitate understanding of the structure and beneficial effects of the photodetector provided in the embodiments of the present application, before introducing the photodetector provided in the embodiments of the present application, the photodetector provided in the related art is introduced first. Please refer to Figs. 2 and 3 together, Fig. 2 is a top view of a photodetector chip provided in an embodiment in the related art, Fig. 3 is a cross-sectional view of the photodetector chip in Fig. 2 along line A-A. The photodetector in the related art (not the related art) includes a first electrode 110, a substrate 120, a buffer layer 130, a light absorption layer 140, a top layer 150, a contact layer 160, a passivation layer 210, an anti-reflection film 220, and a second electrode 180. The first electrode 110, the substrate 120, the buffer layer 130, the light absorption layer 140, the top layer 150, the contact layer 160, and the passivation layer 210 are sequentially stacked. The passivation layer 210 has a through hole 220a, the anti-reflection film 220 and a portion of the second electrode 180 are disposed in the through hole 220a, and the portion of the second electrode 180 is disposed on the contact layer 160.

The light absorption layer 140 contains an In-GaAs material, in other words, the light absorption layer 140 is an InGaAs light absorption layer 140. Therefore, the photodetector chip 100 is also referred to as an InGaAs photodetector chip. A detection signal may enter the light absorption layer 140 via the anti-reflection film 220, and the light absorption layer 140 absorbs the detection signal and responds to the detection signal.

Due to the properties of InGaAs materials, the InGaAs material has a relatively high responsivity to light having a wavelength greater than 1300 nm, such as 1310 nm. However, the InGaAs material will absorb light having a wavelength less than or equal to 750 nm, and the InGaAs photodetector chip 100 in the related art generally has a responsivity of 0.1 A/W to the light having a wavelength less than or equal to 750 nm, and the requirement of a responsivity being less than 0.02 A/W therefore cannot be satisfied.

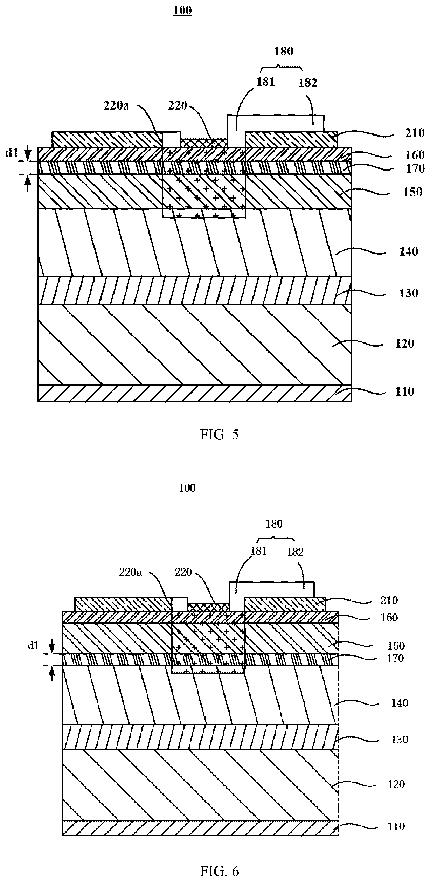

Hereinafter, a photodetector chip 100 provided in embodiments of the present application is introduced. Please refer to Figs. 4 and 5 together, Fig. 4 is a top view of the photodetector chip provided in an embodiment of the present application, and Fig. 5 is a schematic cross-sectional view of the photodetector chip in Fig. 4 along line B-B in an embodiment. The photodetector chip 100 may be applied to devices such as intelligent driving, a robot cleaner, a mobile phone, a tablet computer, a notebook computer, a palmtop computer, a personal computer (PC), a personal digital assistant (PDA), a portable media player (PMP), an earphone, a camera, an intelligent wearable device, an intelligent screen, a display screen, and a wind power generation device. For example, the photodetector chip 100 may be applied to ranging and obstacle avoidance in intelligent driving, or ranging and obstacle avoidance of a robot cleaner; or proximity sensing of a mobile phone, tablet computer, notebook computer, palmtop computer, PC, PDA, smart wearable device, smart screen, display screen, portable media player; or in ear detection of an earphone, atmospheric detection of a camera, or photodetector chips 100 arranged in an array can realize a photographing function of a camera; or deformation detection of wind turbine bladed in a wind power generation equipment. It should be understood that, the foregoing application field of the photodetector chip 100 should not be understood as a limitation to the photodetector chip 100 provided in the embodiment of the present application. The photodetector chip 100 includes a first electrode 110, a substrate 120, a light absorption layer 140, a top layer 150, a second electrode 180, and a filter layer 170. The substrate 120 is disposed on one side of the first electrode 110. The light absorption layer 140 is disposed at one side of the substrate 120 away from the first electrode 110. The top layer 150 is disposed on one side of the light absorption layer 140 away from the substrate 120. The second electrode 180 is in contact with the top layer 150, and the second electrode 180 is disposed at one side of the top layer 150 away from the light absorption layer 140. The filter layer 170 is disposed at one side of the light absorption layer 140 away from the substrate 120 and is located at one side of the second electrode 180 adjacent to the top layer 150. The filter layer 170 is configured to filter out a signal having a wavelength less than 1300 nm and allow a detection signal having a wavelength greater than or equal to 1300 nm to pass through to be transmitted to the light absorption layer 140.

In the schematic diagram of this embodiment, an example in which the filter layer 170 is disposed on a surface of the top layer 150 away from the light absorption layer 140 is illustrated.

The shape of the first electrode 110 may be, but is not limited to, a circle, an ellipse, and the like, which is not limited in this embodiment. The first electrode 110 may be made of, but is not limited to, aurum (Au), and the first electrode 110 includes three first subsidiary conductive layers laminated in sequence. A first layer of the three first sub-conductive layers is aurum-germanium (AuGe), a second layer of the three first sub-conductive layers is nickel (Ni), and a third layer of the three first sub-conductive layers is aurum (Au). A first layer of the three first sub-conductive layers directly contacts the substrate 120, a second layer of the three first sub-conductive layers is located between the first layer and the third layer, and the third layer is away from the first layer compared with the second layer. When the first electrode 110 includes three first sub-conductive layers, a first layer of the three first sub-conductive layers is aurum-germanium (AuGe), a second layer of the three first sub-conductive layers is nickel (Ni), and a third layer of the three first sub-conductive layers is aurum (Au), a contact resistance between the first electrode 110 and the substrate 120 can be small. In other words, an ohmic contact is formed between the first electrode 110 and the substrate 120 to reduce contact resistance. The first electrode 110 may be formed on the back side (view angle shown) of the substrate 120 by an electron beam evaporation process or a thermal evaporation process. In this embodiment, the first electrode 110 is a negative electrode and therefore, the first electrode 110 is also referred to as a negative electrode of a chip.

The thickness of the first electrode 110 may be in the range of 2000 Å to 3000 Å. For example, the thickness of the first electrode 110 may be 2000 Å, 2100 Å, 2200Å, 2300 Å, 2400 Å, 2500 Å, 2600 Å, 2700 Å, 2800 Å, 2900 Å, or 3000 Å. It can be understood that, the thickness of the first electrode 110 may be values other than the above values, as long as the thickness of the first electrode 110 is in the range of 2000 Å to 3000 Å. When the thickness of the first electrode 110 is less than 2000 Å, the contact resistance between the first electrode 110 and the substrate 120 is large, so that the performance of the photodetector chip 100 is poor. When the thickness of the first electrode 110 is greater than 3000 Å, the thickness of the photodetector chip 100 is large, which is unfavorable for lightening and thinning of the photodetector chip 100. In addition, the cost of the photodetector chip 100 is also high. The thickness of the first electrode 110 in the photodetector chip 100 provided in the embodiment of the present application is in the range of 2000Å to 3000Å, on the one hand, the contact resistance between the first electrode 110 and the substrate 120 in the photodetector chip 100 is small, and on the other hand, the cost of the photodetector 100 is low, and the photodetector 100 is light and thin.

The substrate 120 is a base of the photodetector chip 100 and is configured to support other layers in the photodetector chip 100. The substrate 120 is disposed on one side of the first electrode 110, and specifically, the substrate 120 is disposed on a surface of the first electrode 110. Since the first electrode 110 is generally formed on the substrate 120, the relationship between the substrate 120 and the first electrode 110 can be considered that the first electrode 110 is located on the surface of the substrate 120. Typically, the first electrode 110 is disposed on the entire back surface (view angle shown) of the substrate 120. In this embodiment, the substrate 120 is made of InP, in other words, the substrate 120 is an InP substrate. The thickness of the substrate 120 is usually 350 nm. Because of tolerance of the substrate 120 during manufacture, the thickness of the substrate 120 is in a range of 350nm ± 10nm. In other words, the substrate 120 has a thickness of (350-10)nm to (350+10)nm. The substrate 120 may be made by, but is not limited to, a liquid phase crystal pulling process.

The light absorption layer 140 is also referred to as a photoelectric conversion layer, and is configured to convert absorbed light energy into electric energy. In this embodiment, the light absorption layer 140 is configured to receive the detection signal, and convert the detection signal into an electric signal. In this embodiment, the light absorption layer 140 contains InGaAs, in other words, the light absorption layer 140 is an InGaAs light absorption layer. The light absorption layer 140 is disposed at one side of the substrate 120 away from the first electrode 110.

The light absorption layer 140 is disposed at one side of the substrate 120 away from the first electrode 110, and specifically disposed as follows. The light absorption layer 140 may be directly disposed on a surface of the substrate 120 away from the first electrode 110, or another layer may be disposed between the light absorption layer 140 and the substrate 120 and the light absorption layer 140 is not directly disposed on the surface of the substrate 120 away from the first electrode 110.

Typically, InGaAs materials have a relatively high responsivity to light having a wavelength greater than 1300 nm (e. g., 1310 nm) depending on the properties of the InGaAs material. However, the InGaAs material absorbs light having a wavelength less than or equal to 750 nm, and generally has a responsivity of about 0.1 A/W to light having a wavelength less than or equal to 750 nm, which cannot meet the requirement of a responsivity being less than 0.02 A/W.

In the present embodiment, the photodetector chip 100 is provided with the filter layer 170, and the filter layer 170 is disposed at one side of the light absorption layer 140 away from the substrate 120 and is located at one side of the second electrode 180 adjacent to the top layer 150, and the filter layer 170 is configured to filter out a signal having a wavelength less than 1300 nm (for example, visible light having a wavelength less than 750 nm), so that light having a wavelength less than 1300 nm enters less or even cannot enter the light absorption layer 140. Therefore, the light absorption layer 140 in the photodetector chip 100 provided by this embodiment has a low responsivity (such as less than 0.02 A/W) to light with a wavelength less than 1300 nm (for example, visible light having a wavelength less than 750 nm). When the photodetector chip 100 is applied to the proximity sensor 10, the distance detection is more accurate.

The light absorption layer 140 has a thickness of 1.0 μm to 3.0 μm, for example, the light absorption layer 140 has a thickness of 1.0 μm, 1.5 μm, 2.0 μm, 2.5 μm, or 3.0 μm. It can be understood that, the thickness of the light absorption layer 140 may be values other than the above examples, as long as the thickness of the light absorption layer 140 is 1.0 μm to 3.0 μm. When the thickness of the light absorption layer 140 is less than 1.0 μm, the light absorption layer 140 absorbs insufficient detection signals incident on the light absorption layer 140, and partial detection signals (light energy) cannot be converted into electrical signals. When the thickness of the light absorption layer 140 is greater than 3.0 μm, the photodetector chip 100 is not light and thin enough, and the manufacture cost is high. The thickness of the light absorption layer 140 in the photodetector chip 100 provided in the embodiment of the present application is 1.0 μm to 3.0 μm. On the one hand, the light absorption layer 140 can have a good effect of absorbing incident detection signals and converting the same into an electrical signal; on the other hand, the photodetector chip 100 can be lighter and thinner, and the manufacture cost is lower.

The light absorption layer 140 may be prepared by metal-organic chemical vapor deposition (MOCVD) or molecular beam epitaxy (MBE) process.

The top layer 150 is also known as a cap layer. The top layer 150 is disposed at one side of the light absorption layer 140 away from the substrate 120. The top layer 150 is disposed at one side of the light absorption layer 140 away from the substrate 120. In this embodiment, the top layer 150 is disposed on a surface of the light absorption layer 140 away from the substrate 120. The top layer 150 is configured to reduce dark current of the photodetector chip 100. The top layer 150 is made of InP.

Since the light absorption layer 140 is made of InGaAs material, and the InGaAs material has a relatively small band gap, the dark current of the photodetector chip 100 will be relatively large, and the noise of the photodetector chip 100 is relatively large. However, the top layer 150 is made of InP, and the top layer has a relatively large band gap, which may reduce the dark current of the photodetector chip 100. It can be seen therefrom that the band gap of the top layer 150 provided in the embodiment of the present application is greater than the band gap of the light absorption layer 140, and the top layer 150 can reduce the dark current of the photodetector chip 100.

The top layer 150 may have a thickness of 0.5 μm to 1.0 μm. For example, the top layer 150 may have a thickness of 0.5 μm, 0.6 μm, 0.7 μm, 0.8 μm, 0.9 μm, or 1.0 μm. It can be understood that the thickness of the top layer 150 may be values other than the above examples, as long as the thickness of the top layer 150 is 0.5 μm to 1.0 μm. When the thickness of the top layer 150 is less than 0.5 μm, the dark current of the photodetector chip 100 is larger, thus resulting in a larger noise of the photodetector chip 100. When the thickness of the top layer 150 is greater than1.0 μm, formation of the active region by subsequent Zn diffusion is greatly hindered. The top layer 150 in the photodetector chip 100 provided in the embodiment of the present application has a thickness of 0.5 μm to 1.0 μm, which can reduce both the dark current and noise of the photodetector chip 100 and the complexity in subsequent formation of the active region. It should be noted that the noise of the photodetector chip 100 refers to electrical signals other than the electrical signal that is obtained by receiving and converting the detection signal by the photodetector chip 100.

The top layer 150 may be prepared by MOCVD or MBE process.

The second electrode 180 is in contact with the top layer 150, and the second electrode 180 is disposed at one side of the top layer 150 away from the light absorption layer 140. The shape of the second electrode 180 may be described in detail later. The second electrode 180 may be a three-layer second sub-conductive layer. A first layer of the three second conductive sub-layers is made of titanium (Ti), a second layer is made of platinum (Pt), and a third layer is made of aurum (Au). The first layer of the three second sub-conductive layers is adjacent to the substrate 120 as compared to the second layer and the third layer, the second layer is located between the first layer and the third layer, and the third layer faces away from the substrate as compared to the second layer and the first layer. The above-mentioned structure of the second electrode 180 can make the contact resistance between the second electrode 180 and the layer in contact with the second electrode 180 smaller. In other words, an ohmic contact is formed between the second electrode 180 and the layer in contact with the second electrode 180, so that the contact resistance is small. The second electrode 180 may be manufactured by, but is not limited to, an electron beam evaporation process. In this embodiment, the second electrode 180 is a positive electrode, and therefore, the second electrode 180 is also referred to as a positive electrode of a chip.

The second electrode 180 has a thickness in the range of 0.1 μm to 2.0 μm. By way of example, the second electrode 180 has a thickness in the range of 0.1 μm, 0.2 μm, 0.3 μm, 0.4 μm, 0.5 μm, 0.6 μm, 0.7 μm, 0.8 μm, 0.9 μm, 1.0 μm, 1.1 μm, 1.2 μm, 1.3 μm, 1.4 μm, 1.5 μm, 1.6 μm, 1.7 μm, 1.8 μm, 1.9 μm, or 2.0 μm. It can be understood that, the thickness range of the second electrode 180 may be values other than the above examples, as long as the thickness of the second electrode 180 is in a range of 0.1 μm to 2.0 μm. When the thickness of the second electrode 180 is less than0.1 μm, the contact resistance between the second electrode 180 and the layer in contact with the second electrode 180 is larger, so that the photodetector chip 100 has a poor performance. When the thickness of the second electrode 180 is greater than 2.0 $\mu$m, the thickness of the photodetector chip 100 is larger, which is unfavorable for the lightening and thinning of the photodetector chip 100. In addition, the cost of the photodetector chip 100 will be higher. The thickness of the second electrode 180 in the photodetector chip 100 provided by the embodiment of the present application is in a range of 0.1 $\mu$m to 2.0 $\mu$m, which, on the one hand, enables a smaller contact resistance between the layer in contact with the second electrode 180 and the second electrode 180 in the photodetector chip 100, and on the other hand, enables the photodetector 100 to have a lower cost and be lighter and thinner.

The filter layer 170 is disposed at one side of the light absorption layer 140 away from the substrate 120, and is located at one side of the second electrode 180 adjacent to the top layer 150. In other words, the filter layer 170 is located between the light absorption layer 140 and the second electrode 180. Before entering the light absorption layer 140, the light firstly enters the filter layer 170. In other words, when entering the photodetector chip 100, the light firstly passes through the filter layer 170 and then enters the light absorption layer 140. The filter layer 170 is configured to filter out a signal having a wavelength less than 1300 nm and allows a detection signal having a wavelength greater than or equal to 1300 nm to pass through. Therefore, as a result the light filtering function of the filter layer 170, light having a wavelength less than 1300 nm is filtered out, and light having a wavelength greater than or equal to 1300 nm can pass through and then enter the light absorption layer 140.

In an embodiment, the InGaAsP in the filter layer 170 satisfies: $In_{1-x}Ga_xAs_yP_{1-y}$, where x=0.2143, y=0.4655, and therefore, 1-x=0.7857; 1-y = 0.5345. When the InGaAsP in the filter layer 170 satisfies $In_{1-x}Ga_xAs_yP_{1-y}$, x=0.2143, and y=0.4655, the filter layer 170 has a better filtering effect on signals having a wavelength less than 1300 nm.

The working principle of the photodetector chip 100 is introduced below. The photodetector chip 100 is applied to the proximity sensor 10. The proximity sensor 10 further includes a transmission chip 300, where the transmission chip 300 is configured to transmit a detection signal (having a wavelength greater than or equal to 1300 nm, for example, 1310 nm). When the detection signal is transmitted to a target object, the detection signal is reflected by the target object. The photodetector chip 100 receives the detection signal reflected back by the target object, and ambient light (visible light having a wavelength less than 1300 nm and generally less than 750 nm) of an external environment also enters the photodetector chip 100. It can be seen therefrom that the light signals entering the photodetector chip 100 include an ambient light signal in addition to the detection signal. In other words, the incident lights entering the photodetector chip 100 include a detection signal and an ambient light signal. The photodetector chip 100 provided in the embodiment of the present application includes a filter layer 170, and before light signals enter the light absorption layer 140, the filter layer 170 prevents a signal having a wavelength less than 1300 nm from passing through, and allows a detection signal having a wavelength greater than or equal to 1300 nm to pass through. Since the wavelength of the ambient light is less than 1300 nm, and the ambient light is usually visible light having a wavelength of less than 750 nm, it can be seen therefrom that due to the filter layer 170, light having a wavelength of less than 1300 nm is less likely to enter the light absorption layer 140 or even cannot enter the light absorption layer 140. Therefore, in the photodetector chip 100 provided in the embodiment of the present application, the requirement that the responsivity of the light absorption layer 140 to light having a wavelength less than 1300 nm (particularly, less than or equal to 750 nm) is less than 0.02 A/W can be achieved. It can be seen therefrom that the interference of signals having a wavelength of less than 1300 nm such as ambient light on the photodetector chip 100 can be reduced or even avoided. When the photodetector chip 100 is applied to the proximity sensor 10, the accuracy of determining the distance between the target object and the proximity sensor 10 according to the detection signal having a wavelength of 1300 nm or more absorbed by the light absorption layer 140 of the photodetector chip 100 can be improved.

The working principle of the photodetector chip 100 will be described below. When the photodetector chip 100 operates, the photodetector chip 100 is loaded with a reverse bias voltage. Specifically, the first electrode 110 is a negative electrode of the chip, the second electrode 180 is a positive electrode of the chip, the first electrode 110 is applied with a positive voltage, and the second electrode 180 is applied with a negative voltage, therefore, the photodetector chip 100 is applied with a reverse bias voltage. Since the first electrode 110 is applied with a positive voltage and the second electrode 180 is applied with a negative voltage, an electric field is formed between the first electrode 110 and the second electrode 180. The detection signal enters the light absorption layer 140, and a photoelectric reaction occurs. The light absorption layer 140 converts the detection signal serving as light energy into electric energy, and generates electrons and holes. The electrons and holes drift under the action of the electric field formed between the first electrode 110 and the second electrode 180. Specifically, the electrons flow to the second electrode 180 and the holes flow to the first electrode 110, thereby forming a sensing current.

In the schematic diagram of this embodiment, the filter layer 170 is disposed on a surface of the top layer 150 away from the light absorption layer 140. It can be understood that, the schematic diagram of the present embodiment should not be understood as a limitation to the photodetector chip 100 provided in the embodiment of the present application. The top layer 150 is located before the incident light enters the light absorption layer 140, and the filter layer 170 is disposed on the top layer 150, therefore, before the incident light enters the light absorption layer 140, a signal having a wavelength less than 1300 nm can be filtered out, so that the signal having a wavelength less than 1300 nm is less likely or even unable to pass through the filter layer 170, and thus the signal having a wavelength less than 1300 nm is less likely or even unable to enter the light absorption layer 140, so that the detection signal having a wavelength greater than or equal to 1300 nm can pass through. Therefore, interference of the signal having a wavelength less than 1300 nm, such as ambient light, on the photodetector chip 100 is reduced or even avoided. When the photodetector chip 100 is applied to the proximity sensor 10, a detection signal having a wavelength greater than or equal to 1300 nm can enter the light absorption layer 140, so that the accuracy of determining the distance between the target object and the proximity sensor 10 according to the detection signal having a wavelength greater than or equal to 1300 nm absorbed by the light absorption layer 140 of the photodetector chip 100 can be improved.

Further, the filter layer 170 is disposed on a surface of the top layer 150 away from the light absorption layer 140, even if a part of a signal having a wavelength less than 1300 nm in the incident light passes through the filter layer 170, before entering the light absorption layer 140, such part of the signal having a wavelength less than 1300 nm in the incident light firstly enters the top layer 150, where the top layer 150 absorbs the signal having a wavelength less than 1300 nm, thereby further reducing or even avoiding the signal having a wavelength less than 1300 nm entering the light absorption layer 140. Therefore, interference of the signal with the wavelength less than 1300 nm, such as ambient light, on the photodetector chip 100 is reduced or even avoided. When the photodetector chip 100 is applied to the proximity sensor 10, a detection signal having a wavelength greater than or equal to 1300 nm can enter the light absorption layer 140, which can further improve the accuracy of determining the distance between the target object and the proximity sensor 10 according to the detection signal having a wavelength greater than or equal to 1300 nm absorbed by the light absorption layer 140 of the photodetector chip 100.

Please refer to Figs. 4 and 6 together, Fig. 6 is a schematic cross-sectional view of the photodetector chip along line B-B in Fig. 4 according to another embodiment of the present application. The photodetector chip 100 includes a first electrode 110, a substrate 120, a light absorption layer 140, a top layer 150, a second electrode 180, and a filter layer 170. The substrate 120 is disposed on one side of the first electrode 110. The light absorption layer 140 contains InGaAs, and the light absorption layer 140 is disposed at one side of the substrate 120 away from the first electrode 110. The top layer 150 is disposed at one side of the light absorption layer 140 away from the substrate 120. The second electrode 180 is in contact with the top layer 150, and the second electrode 180 is disposed at one side of the top layer 150 away from the light absorption layer 140. The filter layer 170 is disposed at one side of the light absorption layer 140 away from the substrate 120 and is located at one side of the second electrode 180 adjacent to the top layer 150. The filter layer 170 is configured to filter out a signal having a wavelength less than 1300 nm and allow a detection signal having a wavelength greater than or equal to 1300 nm to pass through.

In the schematic diagram of this embodiment, an example in which the filter layer 170 is disposed between the top layer 150 and the light absorption layer 140 is illustrated.

The structure of the photodetector provided in this embodiment is basically the same as that of the photodetector provided in the previous embodiment, and the difference lies in that the positions of the filter layers 170 in the two embodiments are different. In the previous embodiment, the filter layer 170 is disposed on a surface of the top layer 150 away from the light absorption layer 140; in this embodiment, the filter layer 170 is disposed between the top layer 150 and the light absorption layer 140.

The filter layer 170 is disposed between the top layer 150 and the light absorption layer 140. In this embodiment, one surface of the filter layer 170 is disposed on a surface of the light absorption layer 140 away from the substrate 120, and the top layer 150 is disposed on the other surface of the filter layer 170, where the other surface of the filter layer 170 and the one surface of the filter layer 170 are two opposite surfaces.

The filter layer 170 is disposed between the top layer 150 and the light absorption layer 140, so before the incident light enters into the light absorption layer 140, the incident light firstly enters the filter layer 170, and the filter layer 170 can filter out a signal having a wavelength less than 1300 nm, so that the signal having a wavelength less than 1300 nm is less likely or even unable to pass through the filter layer 170, and thus a signal having a wavelength less than 1300 nm is less likely or even unable to enter the light absorption layer 140, so that the detection signal having a wavelength greater than or equal to 1300 nm passes through. Therefore, interference of a signal having a wavelength less than 1300 nm, such as ambient light, on the photodetector chip 100 is reduced or even avoided. When the photodetector chip 100 is applied to the proximity sensor 10, a detection signal having a wavelength greater than or equal to 1300 nm may enter the light absorption layer 140, so that the accuracy of determining the distance between the target object and the proximity sensor 10 according to the detection signal having a wavelength greater than or equal to 1300 nm absorbed by the light absorption layer 140 of the photodetector chip 100 can be improved.

The first electrode 110 is a negative electrode, the second electrode 180 is a positive electrode, the substrate 120 is an InP substrate 120, the light absorption layer 140 is an InGaAs layer, and the filter layer 170 is an InGaAsP layer.

The light absorption layer 140 is an InGaAs layer, in other words, the light absorption layer 140 is made of an InGaAs material. Therefore, the light absorption layer 140 may also be referred to as an InGaAs light absorption layer 140. Correspondingly, the photodetector chip 100 is also referred to as an InGaAs photodetector chip 100. According to the property of the InGaAs material, the InGaAs material has a relatively high responsivity to light having a wavelength greater than 1300 nm (e. g., 1310 nm), and therefore, the photodetector chip 100 has a relatively good responsivity.

The filter layer 170 is an InGaAsP layer, in other words, the filter layer 170 is made of InGaAsP material; therefore, the filter layer 170 is also referred to as InGaAsP filter layer. The filter layer 170 is an InGaAsP layer and can absorb light having a wavelength less than or equal to 1300 nm.

In an embodiment, thickness d1 of the filter layer 170 satisfies: $0.5\mu m \leq d1 \leq 3.0\mu m$.

When the filter layer 170 is an InGaAsP layer, although InGaAsP has a good absorption effect on light having a wavelength less than 1300 nm, however, when the thickness d1 of the filter layer 170 is less than 0.5 $\mu m$, the filter layer 170 has a relatively small thickness, and the filter layer 170 cannot absorb a large quantity of light having a wavelength less than 1300 nm, so that a part of light having a wavelength less than 1300 nm enter the light absorption layer 140, thereby causing interference when the light absorption layer 140 operates with a signal having a wavelength greater than or equal to 1300 nm (for example, 1310 nm). The larger the thickness of the filter layer 170 is, the better the blocking effect on the light having a wavelength less than 1300 nm is; however, the larger thickness of the filter layer 170 will make the thickness of the whole photodetector chip 100 larger, which further goes against the lightening and thinning of the size of the photodetector chip 100. In conclusion, the thickness d1 of the filter layer 170 in the photodetector chip 100 provided in the embodiment of the present application satisfies: $0.5 \mu m \leq d1 \leq 3.0 \mu m$, as such, the blocking effect of the filter layer 170 on lights having a wavelength less than 1300 nm as well as lighting and thinning of the photodetector chip 100 can be both considered.

The thickness d1 of the filter layer 170 satisfies: $0.5 \mu m \leq d1 \leq 3.0 \mu m$, and specifically, the thickness d1 of the filter layer 170 can be 0.5 $\mu m$, 0.6 $\mu m$, 0.7 $\mu m$, 0.8 $\mu m$, 0.9 $\mu m$, 1.0 $\mu m$, 1.1 $\mu m$, 1.2 $\mu m$, 1.3 $\mu m$, 1.4 $\mu m$, 1.5 $\mu m$, 1.6 $\mu m$, 1.7 $\mu m$, 1.8 $\mu m$, 1.9 $\mu m$, 2.0 $\mu m$, 2.1 $\mu m$, 2.2 $\mu m$, 2.3 $\mu m$, 2.4 $\mu m$, 2.5 $\mu m$, 2.6 $\mu m$, 2.7 $\mu m$, 2.8 $\mu m$, 2.9 $\mu m$, or 3.0 $\mu m$. It can be understood that, the thickness d1 of the filter layer 170 may also be values other than the above examples, as long as the thickness d1 of the filter layer 170 satisfies $0.5\mu m \leq d1 \leq 3.0\mu m$.

Further, in an embodiment, the thickness d1 of the filter layer 170 satisfies: $0.5\mu m \leq d1 \leq 1.0\mu m$.

When the filter layer 170 is an InGaAsP layer, InGaAsP has a good absorption effect on light having a wavelength less than 1300 nm, however, when the thickness d1 of the filter layer 170 is less than or equal to 0.5 $\mu m$, the filter layer 170 has a relatively small thickness, and the filter layer 170 cannot absorb a large quantity of lights having a wavelength less than 1300 nm, so that a part of lights having a wavelength less than 1300 nm enter the light absorption layer 140, thereby causing interference when the light absorption layer 140 operates with a signal having a wavelength greater than or equal to 1300 nm (for example, 1310 nm). The larger the thickness of the filter layer 170 is, the better the blocking effect on the light having a wavelength less than 1300 nm is. However, the larger thickness of the filter layer 170 will make the thickness of the whole photodetector chip 100 larger, which further goes against the lightening and thinning of the size of the photodetector chip 100. In addition, considering the manufacturing difficulty and time and other costs when the thickness is large, the thickness of the filter layer 170 is chosen to be d1 which satisfies: $0.5\mu m \leq d1 \leq 1.0\mu m$. In conclusion, the thickness d1 of the filter layer 170 in the photodetector chip 100 provided in the embodiment of the present application satisfies: $0.5\mu m \leq d1 \leq 1.0\mu m$, which takes into account both the blocking effect of the filter layer 170 on lights having a wavelength less than 1300 nm, the lightening and thinning of the photodetector chip 100, and the difficulty and the time cost in preparing the filter layer 170.

The thickness d1 of the filter layer 170 satisfies: $0.5\mu m \leq d1 \leq 1.0\mu m$, and specifically, the thickness d1 of the filter layer 170 may be 0.5$\mu m$, 0.6$\mu m$, 0.7$\mu m$, 0.8$\mu m$, 0.9$\mu m$, or 1.0$\mu m$. It can be understood that, the thickness d1 of the filter layer 170 may also be values other than the above examples, as long as the thickness d1 of the filter layer 170 satisfies $0.5\mu m \leq d1 \leq 1.0\mu m$.

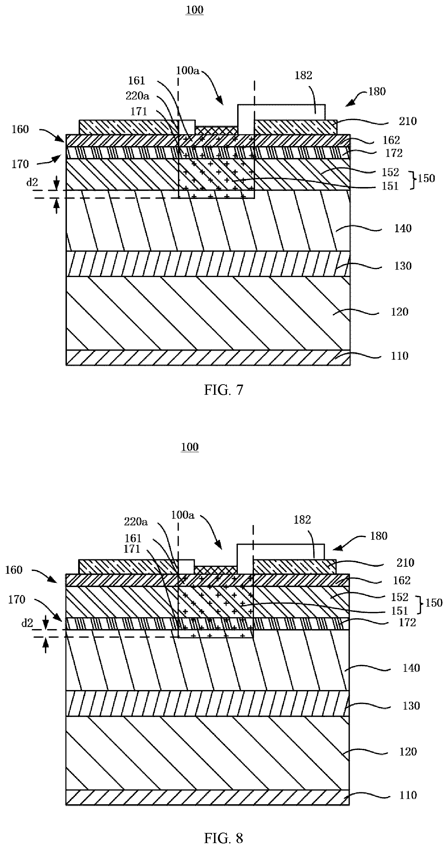

Please refer to Figs. 7 and 8 continuously, Fig. 7 is a schematic diagram of an active region of the photodetector chip shown in Fig. 5, and Fig. 8 is a schematic diagram of an active region of the photodetector chip shown in Fig. 6. In an embodiment, the photodetector chip 100 has an active region 100a. The detection signal can pass through the active region 100a to be transmitted to the light absorption layer 140. A portion of the top layer 150 and a portion of the filter layer 170 in the active region 100a are doped with Zn, and a portion of the light absorption layer 140 in the active region 100a and adjacent to the second electrode 180 is doped with Zn. The thickness (denoted by d2 in the figure) of the portion of the light absorption layer 140 doped with Zn is 0.1 $\mu m$ to 0.2 $\mu m$.

The shape of the top view of the active region 100a may be, but is not limited to, a circle, a square, an ellipse or other shapes, which is not limited in this embodiment.

In the present embodiment, in the photodetector chip 100, the portion of the top layer 150 and the portion of the filter layer 170 that are in the active region 100a are doped with Zn, so that the contact between the second electrode 180 and the light absorption layer 140 is better. In addition, the portion of the light absorption layer 140 located in the active region 100a and adjacent to the second electrode 180 is also doped with Zn, which can further improve the contact between the second electrode 180 and the light absorption layer 140. The thickness of the Zn-doped portion of the light absorption layer 140 may be 0.1 μm to 0.2 μm. The thickness of the Zn-doped portion of the light absorption layer 140 may be, but is not limited to, 0.10 μm, 0.12 μm, 0.13 μm, 0.14 μm, 0.15 μm, 0.16 μm, 0.17 μm, 0.18 μm, 0.19 μm, or 0.20 μm. When the thickness of Zn-doped portion of the light absorption layer 140 is less than 0.1 μm, improvement of the contact effect between the second electrode 180 and the light absorption layer 140 is limited, and when the thickness of the Zn-doped portion of the light absorption layer 140 is greater than 0.2 μm, it is more difficult to dope Zn in the light absorption layer 140. In the embodiment of the present application, the thickness of the Zn-doped portion of the light absorption layer 140 is 0.1 μm to 0.2 μm. On the one hand, the contact effect between the second electrode 180 and the light absorption layer 140 can be better, and on the other hand, the preparation difficulty in Zn doping is reduced.

Please refer to Figs. 7 and 8 together, the top layer 150 includes a first diffusion portion 151 and a body portion 152. The body portion 152 is made of a first material, and the first diffusion portion 151 is made of the first material and Zn. In this embodiment, the first material is InP. The top layer 150 may be formed in a manner of, but not limited to, forming an entire layer of the first material on one side of the light absorption layer 140 away from the substrate 120, doping a portion of the layer of the first material corresponding to the active region 100a with Zn, and diffusing Zn in the layer of the first material corresponding to the active region 100a, so as to form the first diffusion portion 151. In other words, the Zn-doped portion of the layer of the first material is the first diffusion portion 151, and the remaining portion of the layer of the first material is the body portion 152.

Portion of the layer of the first material corresponding to the active region 100a is doped with Zn (namely, the first diffusion portion 151 contains Zn), the second electrode 180 is disposed at one side of the first diffusion portion 151 away from the light absorption layer 140, and the second electrode 180 can better load a voltage to the light absorption layer 140 via the first diffusion portion 151. The above-mentioned structural design of the top layer 150 and the second electrode 180 enables the photodetector chip 100 to have better performance.

Please refer to Figs. 4 to 8 together, the orthographic projection of the filter layer 170 on the substrate 120 completely covers the orthographic projection of the active region 100a on the substrate 120. For ease of description, the orthographic projection of the filter layer 170 on the substrate 120 is named as a first projection, and the orthographic projection of the active region 100a on the substrate 120 is named as a second projection. The orthographic projection of the filter layer 170 on the substrate 120 completely covers the orthographic projection of the active region 100a on the substrate 120, including: the area of the first projection is greater than the area of the second projection, and the second projection is completely within the range of the first projection; or, the area of the first projection is equal to the area of the second projection, and the second projection and the first projection completely coincide with each other. In the schematic diagram of this embodiment, an example in which the area of the first projection is greater than the area of the second projection and the second projection is completely within the range of the first projection is illustrated.

The orthographic projection of the filter layer 170 on the substrate 120 completely covers the orthographic projection of the active region 100a on the substrate 120, therefore, when incident light enters the photodetector chip 100 via the active region 100a, all the incident light entering the photodetector chip 100 irradiates onto the filter layer 170, so that a signal having a wavelength less than 1300 nm in the incident light is filtered out.

Further referring to Figs. 7 and 8, or referring to Figs. 6 and 7 together, the filter layer 170 further includes a second diffusion portion 171, the second diffusion portion 171 is at least partially opposite to the first diffusion portion 151, the filter layer 170 is made of a second material, and the second diffusion portion 171 is made of the second material and Zn. The second material is InGaAsP. The orthographic projection of the second diffusion portion 171 on the substrate 120 completely covers the orthographic projection of the active region 100a on the substrate 120.

In this embodiment, the filter layer 170 includes the second diffusion portion 171, and in addition, the filter layer 170 further includes an edge portion 172. The edge portion 172 is disposed on a peripheral of the second diffusion portion 171. The filter layer 170 may be formed by, but not limited to, forming an entire layer of the second material, doping a portion of the second material layer corresponding to the active region 100a with Zn, and diffusing Zn in the layer of the first material corresponding to the active region 100a, so as to form the second diffusion portion 171. In other words, the Zn-doped portion of the layer of the first material is the second diffusion portion 171, and the remaining portion of the layer of the first material is the edge portion 172 of the filter layer 170.

A portion of the layer of the second material corresponding to the active region 100a is doped with Zn (namely, Zn is contained in the second diffusion portion 171), the second electrode 180 can better load a voltage to the light absorption layer 140 through the first diffusion portion 151 and the second diffusion portion 171, and the described structural design of the filter layer 170 enables the photodetector chip 100 to have better performance.

In this embodiment, the orthographic projection of the second diffusion portion 171 on the substrate 120 completely covers the orthographic projection of the active region 100a on the substrate 120. On the one hand, when incident light enters the photodetector chip 100 via the active region 100a, all the incident light entering the photodetector irradiates the second diffusion portion 171 of the filter layer 170, so that a signal having a wavelength less than 1300 nm in the incident light is filtered out; on the other hand, the second electrode 180 can better load the voltage to the light absorption layer 140 through the first diffusion portion 151 and the second diffusion portion 171, and the described structural design of the filter layer 170 enables the photodetector chip 100 to have better performance.

The photodetector chip 100 has an active region 100a for receiving the detection signal. A layer (for example, the top layer 150, the contact layer 160, and the filter layer 170) located in the active region 100a and at one side of the light absorption layer 140 away from the substrate 120 is doped with Zn, and therefore, the active region 100a is also referred to as a Zn diffusion region. The active region 100a may be formed by, but is not limited to, a metal-organic chemical vapor deposition (MOCVD) process or a thermal diffusion process.

In an embodiment, the thickness of the photodetector chip 100 doped with Zn is a sum of thicknesses of Zn-doped portions of the top layer 150, the contact layer 160, the filter layer 170, and the light absorption layer 140. For example, in an embodiment, the thickness range of the top layer 150 is 0.5 $\mu$m to 1 $\mu$m, the thickness of the contact layer 160 is 0.1 $\mu$m to 0.2 $\mu$m, the thickness range of the filter layer 170 is 0.5 $\mu$m to 3.0 $\mu$m, and the thickness of the Zn-doped portion of the light absorption layer 140 is 0.1 $\mu$m to 0.2 $\mu$m, therefore, the thickness of the Zn-doped portion of the photodetector chip 100 is 1.2 $\mu$m to 4.4 $\mu$m. Continuing to refer to Figs. 4 and 5, or Figs. 6 and 7, the photodetector chip 100 also includes a buffer layer 130. The buffer layer 130 is disposed between the substrate 120 and the light absorption layer 140, and a lattice matching degree between the buffer layer 130 and the light absorption layer 140 is greater than a lattice matching degree between the substrate 120 and the light absorption layer 140.

The lattice matching degree between the buffer layer 130 and the light absorption layer 140 is greater than that between the substrate 120 and the light absorption layer 140. When the lattice matching degree between the light absorption layer 140 and the substrate 120 is poor, if the light absorption layer 140 is directly formed on the substrate 120, the light absorption layer 140 tends to have many defects. The more defects of the light absorption layer 140 are likely to lead to a poor response of the light absorption layer 140 to the detection signal passing through the filter layer 170. In the embodiment of the present application, the buffer layer 130 is disposed between the substrate 120 and the light absorption layer 140, in other words, the light absorption layer 140 is disposed on the substrate 120 via the buffer layer 130. Since the lattice matching degree between the buffer layer 130 and the light absorption layer 140 is greater than that between the substrate 120 and the light absorption layer 140, therefore, when the light absorption layer 140 is formed on the buffer layer 130, as a result, the light absorption layer 140 has a good response to the detection signal passing through the filter layer 170, thereby improving the performance of the photodetector chip 100. Specifically, since the substrate 120 has many defects, and if the light absorption layer 140 is directly disposed on the substrate 120, the dark current of the photodetector chip 100 is large. In this embodiment, the lattice matching degree between the buffer layer 130 and the light absorption layer 140 is greater than the lattice matching degree between the substrate 120 and the light absorption layer 140, and therefore, the buffer layer 130 can overcome defects of the substrate 120, so that the dark current of the photodetector chip 100 is relatively small.

The substrate 120 is made of InP, and the buffer layer 130 is made of N-InP. In other words, the substrate 120 is an InP substrate, and the buffer layer 130 is an N-InP buffer layer. The term N-InP refers to of N-type InP, and in general, Si is doped into an InP material.

With continued reference to Fig. 4 to Fig. 8, the photodetector chip 100 further includes a contact layer 160, the contact layer 160 is disposed at one side of the top layer 150 away from the light absorption layer 140, and the band gap of the contact layer 160 is less than the band gap of the top layer 150.

The top layer 150 is made of InP, and the contact layer 160 is made of InGaAsP or InGaAs. The band gap of the contact layer 160 is less than that of the top layer 150, thereby reducing the contact resistance between the second electrode 180 and the light absorption layer 140.

The contact layer 160 has a thickness of 0.10 $\mu$m to 0.20 $\mu$m. For example, the contact layer 160 has a thickness of 0.10 $\mu$m, 0.12 $\mu$m, 0.14 $\mu$m, 0.15 $\mu$m, 0.16 $\mu$m, 0.18 $\mu$m, or 0.2 $\mu$m. When the thickness of the contact layer 160 is less than 0.10 $\mu$m, the contact resistance of the second electrode 180 is larger. When the thickness of the contact layer 160 is greater than 0.20 $\mu$m, the contact layer 160 has a blocking effect on Zn diffusion when forming the active region 100a, which may result in that the Zn cannot be diffused to a layer below the contact layer 160 more evenly. In the embodiment of the present application, the thickness of the contact layer 160 is 0.10 $\mu$m to 0.20 $\mu$m, so that on the one hand, the contact resistance of the second electrode 180 is relatively small, and on the other hand, the hindrance to Zn diffusion is relatively small, facilitating the uniform diffusion of Zn to a layer(s) below 160.

The contact layer 160 may be prepared by MOCVD or MBE process.

Please refer to Figs. 7 to 8 together, it can be understood that the contact layer 160 includes a third diffusion portion 161 and a contact body 162. The third diffusion portion 161 is located in the active region, the contact body 162 surrounds the third diffusion portion 161, and the contact body 162 is located in the inactive area. The contact body 162 is made of a third material, where the third material is InGaAs, and the third diffusion portion 161 contains a third material and Zn.

Further, referring to Figs. 4 to 8 together, the photodetector chip 100 further includes a passivation layer 210. The passivation layer 210 is disposed at one side of the contact layer 160 away from the substrate 120, and has a through hole 220a. The through hole 220a defines the active region 100a, and the thickness of the passivation layer 210 is 0.1 μm to 2.0 μm.

The passivation layer 210 is configured to reduce the dark current of the photodetector chip 100. Because the passivation layer 210 is located on a surface of the photodetector chip 100, the passivation layer 210 is also referred to as a surface passivation layer. Since the passivation layer 210 is located on the surface of the photodetector chip 100, the passivation layer 210 also serves to protect the surface of the photodetector chip 100. The passivation layer 210 can be made of but is not limited to silicon oxide ($SiO_2$) or silicon nitride ($SiN_x$).

The thickness of the passivation layer 210 may be, but is not limited to, 0.1 μm, 0.11 μm, 0.12 μm, or 0.13 μm, or 0.14 μm, or 0.15 μm, or 0.16 μm, or 0.17 μm, or 0.18 μm, or 0.19 μm, or 2.0 μm. It can be understood that, the thickness of the passivation layer 210 may be values other than the above examples, as long as the thickness of the passivation layer 210 is 0.1 μm to 2.0 μm. When the thickness of the passivation layer 210 is less than 0.1 μm, when performing Zn doping, there is a risk that Zn cannot be completely prevented from entering into various layers below the passivation layer 210, and if Zn enters into the layers under the passivation layer 210 via the passivation layer 210, the dark current of the photodetector chip 100 will be large. When the thickness of the passivation layer 210 is greater than 0.20 μm, it is difficult to form the through hole 220a in the passivation layer 210. In the photodetector chip 100 provided in the embodiment of the present application, the thickness of the passivation layer 210 is 0.1 μm to 2.0 μm, which, on the one hand, can provide a blocking effect for Zn doping, and specifically, can prevent Zn from diffusing to a layer covered by the passivation layer 210, and on the other hand, can reduce the difficulty in forming the through hole 220a.

Further, referring to Figs. 4 to 8 together, the photodetector chip 100 provided in this embodiment further includes an anti-reflection film 220. The anti-reflection film 220 is arranged in the through hole 220a. The anti-reflection film 220 is configured to reduce the reflectivity of the incident light, so that more incident light enters the photodetector chip 100. Specifically, in the present embodiment, the anti-reflection film 220 is configured to make the detection signal incident on the anti-reflection film 220 have a higher transmittance. The thickness of the anti-reflection film 220 is greater than or equal to 0.1 μm. In this embodiment, the thickness of the anti-reflection film 220 is 1300/(4n)nm -1330/(4n)nm, where n is the refractive index of the anti-reflection film 220. For example, the thickness of the anti-reflection film 220 may be [1300/(4n)]nm, [1310/(4n)]nm, [1320/(4n)]nm, or [1330/(4n)]nm. When the thickness of the anti-reflection film 220 is [1300/(4n)]nm, the anti-reflection film 220 has the highest transmittance to a detection signal of 1300 nm, and the anti-reflection film 220 has a lower transmittance to other wavelength bands. When the thickness of the anti-reflection film 220 is [1310/(4n)]nm, the anti-reflection film 220 has the highest transmittance to a detection signal of 1310 nm, and the anti-reflection film 220 has a lower transmittance to other wavebands. When the thickness of the anti-reflection film 220 is [1320/(4n)]nm, the anti-reflection film 220 has the highest transmittance to a detection signal of 1320 nm, and the anti-reflection film 220 has a lower transmittance to other wavebands. When the thickness of the anti-reflection film 220 is [1330/(4n)]nm, the anti-reflection film 220 has the highest transmittance to a detection signal of 1330 nm, and the anti-reflection film 220 has a lower transmittance to other wavebands.

When the thickness of the anti-reflection film 220 is 1300/(4n)nm to 1330/(4n)nm, the anti-reflection film 220 has a higher transmittance to a detection signal having a wavelength of 1300 nm to 1330 nm, and has a lower transmittance to light having a wavelength less than 1300 nm. In other words, the thickness of the anti-reflection film 220 is 1300/(4n)nm to 1330/(4n)nm, and the transmittance of the anti-reflection film 220 to a detection signal having a wavelength of 1300 nm to 1330 nm is higher than the transmittance of the anti-reflection film 220 to the light having a wavelength of less than 1300 nm.

The anti-reflection film 220 may be made of, but is not limited to, silicon oxide ($SiO_2$) or silicon nitride ($SiN_x$). The anti-reflection film 220 may be prepared by, but is not limited to, plasma enhanced chemical vapor deposition (PECVD).

An annular gap is defined between a periphery of the anti-reflection film 220 and a peripheral side wall of the passivation layer 210 forming the through hole 220a. The second electrode 180 includes a first conductive portion 181 and a second conductive portion 182. The first conductive portion 181 is located in the annular gap and arranged around the anti-reflection film 220. The second conductive portion 182 is located on a surface of the passivation layer 210 away from the substrate 120. The second conductive portion 182 is electrically connected to the first conductive portion 181.

Please also refer to Fig. 4, the photodetector chip 100 further includes a mark part 230 disposed on the passivation layer 210 and spaced apart from the second electrode 180.

The mark part 230 is used for alignment in the manufacturing process of the photodetector chip 100, or is used as an appearance part to distinguish different photodetector chips 100. The mark part 230 is not a component having a photoelectric detection function in the operation of the photodetector chip 100, and therefore, the mark part 230 is also referred to as a non-functional part, and a region where the mark part 230 is located is also referred to as a non-functional region or a mark region.

In this embodiment, the mark part 230 and the second electrode 180 are made of the same material, and the mark part 230 and the second electrode 180 may be prepared in the same preparation process, so as to save the preparation process.

Please refer to Figs. 4 to 8 together, the periphery of the filter layer 170 is exposed beyond the passivation layer 210, so that when the photodetector chip 100 is prepared, a plurality of photodetector chips 100 are generally prepared together. The plurality of photodetector chips 100 are spaced apart from one another, and the periphery of the filter layer 170 is exposed beyond the passivation layer 210 between two adjacent photodetector chips 100. After preparation of the plurality of photodetector chips 100 is completed, the plurality of photodetector chips 100 are usually divided at positions where the filter layer 170 is exposed beyond the passivation layer 210, so as to obtain a plurality of individual photodetector chips 100. It can be seen that, the region where the periphery of the filter layer 170 is exposed beyond the passivation layer 210 is a region where the photodetector chips 100 are divided, and therefore is also referred to as a line marking region.

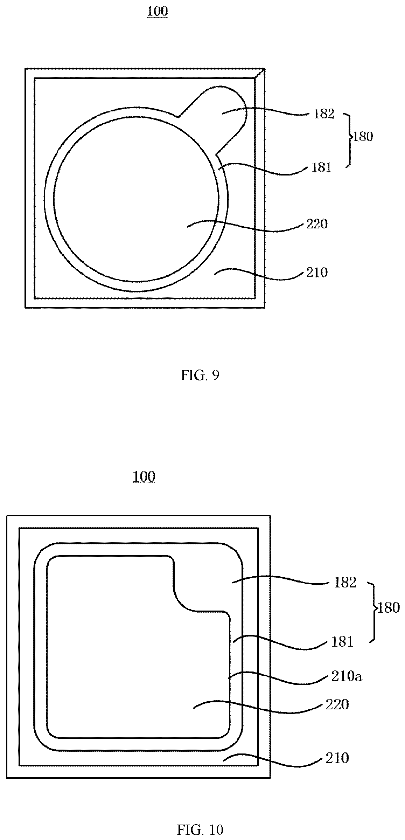

It can be understood that the photodetector chip 100 introduced in the top view of Fig. 4 and the embodiments related thereto does not limit the photodetector chip 100 provided in the embodiments of the present application. The top view of the photodetector chip 100 can also be in other forms, for example, please refer to Figs. 9 and 10 together, Fig. 9 is a top view of a photodetector chip provided by another embodiment of the present application, and Fig. 10 is a top view of a photodetector chip provided in still another embodiment of the present application.

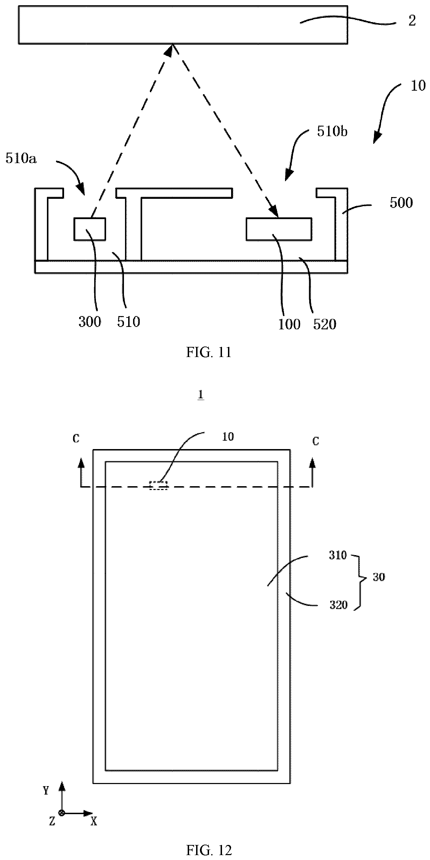

Please refer to Fig. 11, Fig. 11 is a schematic diagram of a proximity sensor according to an embodiment of the present application. The present application further provides a proximity sensor 10. The proximity sensor 10 includes a transmission chip 300 and a photodetector chip 100. The transmission chip 300 is configured to transmit a detection signal. For the photodetector chip 100, refer to the foregoing description, and no further details are provided herein. The filter layer 170 in the photodetector chip 100 is configured to filter out a signal having a wavelength less than 1300 nm, and allow a detection signal having a wavelength greater than or equal to 1300 nm to pass through.

A wavelength of the detection signal transmitted by the transmission chip 300 is greater than or equal to 1300 nm, for example, is 1310 nm. A signal having a wavelength greater than or equal to 1300 nm is a signal in an infrared band. When the detection signal transmitted by the transmission chip 300 is reflected by the target object, the reflected detection signal may enter the photodetector chip 100, and external ambient light may also enter the photodetector chip 100. The ambient light is typically light has a wavelength less than 1300 nm, e. g., visible light having a wavelength less than 750 nm.

The filter layer 170 in the photodetector chip 100 is configured to filter out a signal having a wavelength less than 1300 nm, and allow a detection signal having a wavelength greater than or equal to 1300 nm to pass through. Therefore, interference of a signal having a wavelength less than 1300 nm to a detection signal having a wavelength greater than or equal to 1300 nm transmitted by the transmission chip 300 can be avoided. Thus, improve the accuracy of determining the distance between the target object and the proximity sensor 10 according to absorbing of a detection signal having a wavelength greater than or equal to 1300 nm at the light absorption layer 140 of the photodetector chip 100.

In one embodiment, the proximity sensor 10 includes a packaging case 500. The packaging case 500 has a first accommodating space 510 and a second accommodating space 520 spaced from each other, a first opening 510a communicating with the first accommodating space 510, and a second opening 510b communicating with the second accommodating space 520. The first accommodating space 510 is used for accommodating the transmission chip 300, and a detection signal transmitted by the transmission chip 300 may be transmitted out through the first opening 510a. The detection signal transmitted from the first opening 510a is reflected by the target object 2 and enters the photodetector chip 100 through the second opening 510b. The second accommodating space 520 is used for accommodating the photodetector chip 100, and the photodetector chip 100 can receive the detection signal through the second opening 510b.

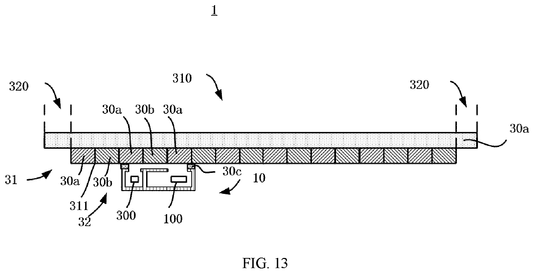

Referring to Figs. 12 and 13, Fig. 12 is a schematic diagram of an electronic device according to an embodiment of the present application; FIG 13 is a cross-sectional view taken along a line C-C in FIG. 12. The present application further provides an electronic device 1. The electronic device 1 may be, but is not limited to, a device having a distance sensing function, such as intelligent driving, a robot cleaner, a mobile phone, a tablet computer, a notebook computer, a palmtop computer, a personal computer (PC), a personal digital assistant (PDA), a portable media player (PMP), an earphone, a camera, an intelligent wearable device, an intelligent screen, a display screen, and a wind power generation device.

In one embodiment, the electronic device 1 includes a display screen 30 and a proximity sensor 10. The display screen 30 is an organic light transmitting diode (OLED) display screen. In other embodiments, the display screen 30 may also be a liquid crystal display screen. The display screen 30 has a display region 310. The display region 310 refers to a region having a display function in the display screen 30. The proximity sensor 10 is arranged at one side of the display screen 30 and is arranged corresponding to a display region 310 of the display screen 30. A transmission chip 300 of the proximity sensor 10 is configured to transmit a detection signal towards the display screen 30. A photodetector chip 100 of the proximity sensor 10 is configured to receive the detection signal passing through the display screen 30, where the wavelength of the detection signal is greater than or equal to 1300 nm.

The proximity sensor 10 arranged corresponding to the display region 310 of the display screen 30 refers to that the orthographic projection of the proximity sensor 10 on the display screen 30 falls into the range of the display region 310. In this embodiment, the display screen 30 may be an organic light emitting diode (OLED) display screen. When the display screen 30 is an OLED display screen, a detection signal having a wavelength greater than or equal to 1300 nm and transmitted by the transmission chip 300 in the proximity sensor may pass through the display screen 30, and therefore, the proximity sensor 10 is correspondingly disposed in the display region 310 of the display screen 30. When the proximity sensor 10 is arranged corresponding to the display region 310 of the display screen 30, there is no need to arrange the proximity sensor 10 in the non-display region 320 of the display screen 30 and the display screen 30 does not have to be holed in the non-display region 320 so as to arrange the proximity sensor 10. It can be seen therefrom that the electronic device 1 provided in the embodiment of the present application has relatively high screen-to-body ratio.

Please refer to Fig. 12, in this embodiment, the display screen 30 further includes a non-display region 320, and the non-display region 320 is disposed at a periphery of the display region 310. The non-display region 320 is a region does not have the display function in the display screen 30, and it can be understood that the proximity sensor 10 may also be arranged corresponding to the non-display region 320 of the display screen 30. The transmission chip 300 of the proximity sensor 10 transmits a detection signal towards the display screen 30, and the photodetector chip 100 of the proximity sensor 10 is configured to receive the detection signal transmitted through the display screen 30, where the wavelength of the detection signal is greater than or equal to 1300 nm. It can be understood that the display screen 30 may also not have the non-display region 320, and the present application does not limit whether the display screen 30 has the non-display region 320.

With further reference to Fig. 13, the display panel 30 includes a pixel defining layer 31 and a light emitting layer 32. The pixel defining layer 31 includes a plurality of pixel opening areas 311 and a plurality of pixel defining portion 30a surround to define the pixel opening areas 311. The light-emitting layer 32 includes a plurality of light-emitting units 30b, and the light-emitting unit 30b is disposed in the pixel opening region 311. The transmission chip 300 and the photodetector chip 100 of the proximity sensor 10 are arranged corresponding to the same pixel defining portion 30a between two adjacent light-emitting units 30b, or the transmission chip 300 and the photodetector chip 100 of the proximity sensor 10 are arranged corresponding to a plurality of pixel defining portions 30a, where the plurality of pixel defining portions 30a are located in the same row or the same column.

When the transmission chip 300 and the photodetector chip 100 of the proximity sensor 10 are arranged corresponding to the same pixel defining portion 30a between two adjacent light-emitting units 30b, or the transmission chip 300 and the photodetector chip 100 of the proximity sensor 10 are arranged corresponding to plurality of pixel defining portions 30a, and the plurality of pixel defining portions 30a are located in the same row or column, the detection signal transmitted by the transmission chip 300 may be less or even not blocked by the light emitting unit 30b, therefore, more detection signal can be transmitted out of the display screen 30. In addition, the detection signal reflected back by the target object may be less or even not blocked by the light emitting unit 30b, and more detection signal reflected can incident into the photodetector chip 100, thereby improving the accuracy of the proximity sensor in determining the distance between the target object and the electronic device 1 according to the detection signal transmitted by the transmission chip 300 and according to the detection signal reflected by the photodetector chip 100. Further, when the transmission chip 300 and the photodetector chip 100 of the proximity sensor 10 are arranged corresponding to the same pixel defining portion 30a between two adjacent light-emitting units 30b, or, the transmission chip 300 and the photodetector chip 100 of the proximity sensor 10 are arranged corresponding to a plurality of pixel defining portions 30a, and the plurality of pixel defining portions 30a are located in the same row or column, the light transmission chip 300 and the photodetector chip 100 of the proximity sensor 10 are not directly spaced apart by the light emitting unit 30b. Therefore, the interference of the light emitted from the light-emitting unit 30b with the photodetector chip 100 when entering into the photodetector chip 100 can be reduced.

In one embodiment, the pixel defining portion 30a may be made of an InGaAsP four-element material. The pixel defining portion 30a may define the pixel opening region 311 on one hand, and absorb light having a wavelength less than 1300 nm and allow light having a wavelength greater than or equal to 1300 nm to pass through on the other hand. In the present embodiment, the pixel defining portion 30a may further block light having a wavelength less than 1300 nm.

Further, the display screen 30 further includes a light blocking member 30c. The light blocking member 30c is disposed on the periphery of the proximity sensor 10 and seals a gap between the proximity sensor 10 and the display screen 30, so as to prevent lights from entering the photodetector chip 100 in the proximity sensor 10 through the gap between the display screen 30 and the proximity sensor 10.

In the present embodiment, the display screen 30 further includes a packaging member, and the packaging member is disposed at one side of the light-emitting unit 30b away from the proximity sensor 10 and is used for protecting the light-emitting unit 30b.

Although the embodiments of the present application have been shown and described, it should be understood that the above embodiments are illustrative and cannot be construed as limitations to the present application. Those skilled in the art can make changes, modifications, replacements, and variations to the above embodiments within the scope of the present application, and these changes and modifications shall also belong to the scope of protection of the present application.

**Claims**

1. A photodetector chip, comprising:

    a first electrode;
    a substrate disposed on one side of the first electrode;
    a light absorption layer disposed at one side of the substrate away from the first electrode;
    a top layer disposed on one side of the light absorption layer away from the substrate;
    a second electrode in contact with the top layer and disposed on one side of the top layer away from the light absorption layer; and
    a filter layer disposed at one side of the light absorption layer away from the substrate and located at one side of the second electrode adjacent to the top layer, the filter layer being configured to filter out a signal having a wavelength less than 1300 nm and allow a detection signal having a wavelength greater than or equal to 1300 nm to pass through to the light absorption layer.

2. The photodetector chip of claim 1, wherein

    the filter layer is disposed on a surface of the top layer away from the light absorption layer; or
    the filter layer is disposed between the top layer and the light absorption layer.

3. The photodetector chip of claim 2, wherein the first electrode is a negative electrode, the second electrode is a positive electrode, the substrate is an InP substrate, the light absorption layer is an InGaAs layer, and the filter layer is an InGaAsP layer.

4. The photodetector chip of claim 3, wherein InGaAsP in the filter layer satisfies: $In_{1-x}Ga_xAs_yP_{1-y}$, wherein x=0.2143 and y=0.4655.

5. The photodetector chip of claim 4, wherein a thickness d1 of the filter layer satisfies: $0.5\ \mu m \leq d1 \leq 3.0\ \mu m$.

6. The photodetector chip of any one of claims 1 to 5, wherein the photodetector chip has an active region, the active region allows the detection signal to pass through to the light absorption layer, a portion of the top layer and a portion of the filter layer that are located in the active region are doped with Zn, and a portion of the light absorption layer located in the active region and adjacent to the second electrode is doped with Zn, wherein a thickness of the portion of the light absorption layer doped with Zn is 0.1 $\mu m$ to 0.2 $\mu m$.

7. The photodetector chip of claim 1, further comprising:
    a buffer layer disposed between the substrate and the light absorption layer, a lattice matching degree between the buffer layer and the light absorption layer is greater than a lattice matching degree between the substrate and the light absorption layer.

8. The photodetector chip of claim 6, further comprising:
    a contact layer disposed at one side of the top layer away from the light absorption layer, a portion of the contact layer located in the active region being doped with Zn, a band gap of the contact layer being less than a band gap of the top layer.

9. The photodetector chip of claim 8, further comprising:

    a passivation layer disposed on one side of the contact layer away from the substrate, the passivation layer having a through hole, and the through hole defining the active region; and
    an anti-reflection film disposed in the through hole, an annular gap being defined between a periphery of the anti-reflection film and a peripheral side wall of the passivation layer forming the through hole;
    the second electrode comprising a first conductive portion and a second conductive portion, wherein the first conductive portion is located in the annular gap and is arranged around the anti-reflection film, the second conductive portion is disposed on a surface of the passivation layer away from the substrate, and the second conductive portion is electrically connected to the first conductive portion.

**10.** A photodetector chip, comprising:

a first electrode;

a substrate disposed on one side of the first electrode;

a light absorption layer, wherein the light absorption layer is an InGaAs layer, a thickness of the light absorption layer is 1.0 μm to 3.0 μm, and the light absorption layer is disposed at one side of the substrate away from the first electrode;

a top layer disposed at one side of the light absorption layer away from the substrate, a band gap of the top layer being greater than a band gap of the light absorption layer, and a thickness of the top layer being 0.5 μm to 1.0 μm;

a contact layer disposed at one side of the top layer away from the light absorption layer;

a passivation layer disposed on one side of the contact layer away from the substrate, the passivation layer having a through hole, the through hole defining an active region, and a thickness of the passivation layer being 0.1 μm to 2.0 μm;

an anti-reflection film disposed in the through hole, an annular gap is defined between a periphery of the anti-reflection film and a peripheral side wall of the passivation layer forming the through hole, a thickness of the anti-reflection film being 1300/(4n)nm to 1330/(4n)nm, and n being a refractive index of the anti-reflection film;

a second electrode in contact with the top layer and disposed on one side of the top layer away from the light absorption layer; and

a filter layer disposed at one side of the light absorption layer away from the substrate and located at one side of the second electrode adjacent to the top layer, wherein the filter layer is configured to filter out a signal having a wavelength less than 1300 nm, and allow a detection signal having a wavelength greater than or equal to 1300 nm to pass through to the light absorption layer, a responsivity of the light absorption layer to a light having a wavelength less than 1300 nm is less than 0.02 A/W.

**11.** The photodetector chip of claim 10, wherein

the filter layer is disposed on a surface of the top layer away from the light absorption layer; or

the filter layer is disposed between the top layer and the light absorption layer.

**12.** The photodetector chip of claim 11, wherein the first electrode is a negative electrode, the second electrode is a positive electrode, the substrate is an InP substrate, and the filter layer is an InGaAsP layer.

**13.** The photodetector chip of claim 12, wherein In-

GaAsP in the filter layer satisfies: $In_{1-x}Ga_xAs_yP_{1-y}$, wherein x=0.2143, and y=0.4655.

**14.** The photodetector chip of claim 13, wherein a thickness d1 of the filter layer satisfies:

$$0.5\mu m \leqslant d1 \leqslant 3.0\mu m.$$

**15.** The photodetector chip of any one of claims 10 to 14, wherein the photodetector chip has an active region, the active region allows the detection signal to pass through to the light absorption layer, a portion of the top layer and a portion of the filter layer that are located in the active region are doped with Zn, and a portion of the light absorption layer located in the active region and adjacent to the second electrode is doped with Zn, and a thickness of the portion of the light absorption layer doped with Zn is 0.1 μm to 0.2 μm.

**16.** The photodetector chip of claim 10, further comprising:
a buffer layer disposed between the substrate and the light absorption layer, a lattice matching degree between the buffer layer and the light absorption layer being greater than a lattice matching degree between the substrate and the light absorption layer.

**17.** The photodetector chip of claim 15, wherein
a portion of the contact layer located in the active region is doped with Zn, and a band gap of the contact layer is less than a band gap of the top layer.

**18.** The photodetector chip of claim 17, wherein
the second electrode comprises a first conductive portion and a second conductive portion, wherein the first conductive portion is located in the annular gap and is arranged around the anti-reflection film, the second conductive portion is disposed on a surface of the passivation layer away from the substrate, and the second conductive portion is electrically connected to the first conductive portion.

**19.** A proximity sensor, comprising:

a transmission chip configured to transmit a detection signal;
the photodetector chip of any one of claims 1 to 18, wherein the filter layer in the photodetector chip is configured to filter out a signal having a wavelength less than1300 nm and allow a detection signal having a wavelength greater than or equal to 1300 nm to pass through.

**20.** An electronic device, comprising:

a display screen having a display region; and

the proximity sensor of claim 19, wherein the proximity sensor is disposed at one side of the display screen and corresponds to the display region of the display screen; the transmission chip of the proximity sensor is configured to transmit the detection signal towards the display screen and the photodetector chip of the proximity sensor is configured to receive the detection signal which pass through the display screen, wherein a wavelength of the detection signal is greater than or equal to 1300 nm.

FIG. 1

FIG. 2

100

220a  220

180
210
160

150

140

130

120

110

FIG. 3

100

B

210

182

180

181

230

B

220

FIG. 4

100

180

181   182

220a   220

210

d1

160
170

150

140

130

120

110

FIG. 5

100

180

181   182

220a   220

210

160

d1

150
170

140

130

120

110

FIG. 6

FIG. 7

FIG. 8

100

182
} 180
181

220

210

FIG. 9

100

182
} 180
181

210a

220

210

FIG. 10

2

10

510b

510a

500

300   510

100   520

FIG. 11

1

C          10          C

310
}30
320

Y
Z      X

FIG. 12

FIG. 13

## INTERNATIONAL SEARCH REPORT

| International application No. |
| --- |
| **PCT/CN2023/108864** |

| A. | CLASSIFICATION OF SUBJECT MATTER |
| --- | --- |

H01L31/101(2006.01)i;　H01L31/0232(2014.01)i;　G01S17/08(2006.01)i

According to International Patent Classification (IPC) or to both national classification and IPC

| B. | FIELDS SEARCHED |
| --- | --- |

Minimum documentation searched (classification system followed by classification symbols)

IPC: H01L, G01S

Documentation searched other than minimum documentation to the extent that such documents are included in the fields searched

Electronic data base consulted during the international search (name of data base and, where practicable, search terms used)

CNABS, CNTXT, DWPI, ENTXTC, WPABSC, CNKI: 光电, 探测, 距离, 传感器, 电极, 滤, 吸收, 透过, 1.3微米, 1300纳米, 响应度, 灵敏度, photoelectric, detect+, distance, sensor, electrode, filt+, absorb+, transmiss+, 1300nm, InGaAs, InGaAsP, Inp, 1.3μm, response degree, A/W

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| PX | CN 115458624 A (PHOGRAIN TECHNOLOGY (SHENZHEN) CO., LTD.) 09 December 2022 (2022-12-09)<br>　　　claims 1-11, description, paragraphs [0003]-[0102], and figures 1-13 | 1-20 |
| PX | CN 115458623 A (PHOGRAIN TECHNOLOGY (SHENZHEN) CO., LTD.) 09 December 2022 (2022-12-09)<br>　　　claims 1-10, description, paragraphs [0003]-[0112], and figures 1-14 | 1-20 |
| X | JP H05343728 A (SUMITOMO ELECTRIC INDUSTRIES, LTD.) 24 December 1993 (1993-12-24)<br>　　　description, paragraphs 0002-0028, and figures 1-11 | 1, 2, 4-6, 19, 20 |
| Y | JP H05343728 A (SUMITOMO ELECTRIC INDUSTRIES, LTD.) 24 December 1993 (1993-12-24)<br>　　　description, paragraphs 0002-0028, and figures 1-11 | 3, 7-9 |
| Y | CN 104576786 A (SHENZHEN PHOGRAIN INTERNATIONAL TECHNOLOGY DEVELOPMENT CO., LTD.) 29 April 2015 (2015-04-29)<br>　　　description, paragraphs 0007-0043, and figures 1-11 | 3, 7-9 |

☑ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **18 October 2023** | **03 November 2023** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
|---|
| **PCT/CN2023/108864** |

### C. DOCUMENTS CONSIDERED TO BE RELEVANT

| Category* | Citation of document, with indication, where appropriate, of the relevant passages | Relevant to claim No. |
|---|---|---|
| A | JP 2001085729 A (SUMITOMO ELECTRIC INDUSTRIES, LTD.) 30 March 2001 (2001-03-30)<br>entire document | 1-20 |
| A | CN 105552161 A (SHENZHEN PHOGRAIN INTELLIGENT SENSING TECHNOLOGY CO., LTD.) 04 May 2016 (2016-05-04)<br>entire document | 1-20 |
| A | CN 109216495 A (SHENZHEN PHOGRAIN INTELLIGENT SENSING TECHNOLOGY CO., LTD.) 15 January 2019 (2019-01-15)<br>entire document | 1-20 |
| A | US 2002158268 A1 (MATSUSHITA ELECTRIC INDUSTRIAL CO., LTD.) 31 October 2002 (2002-10-31)<br>entire document | 1-20 |
| A | US 2003151057 A1 (SUMITOMO ELECTRIC INDUSTRIES, LTD.) 14 August 2003 (2003-08-14)<br>entire document | 1-20 |
| A | US 2006202297 A1 (MITSUBISHI ELECTRIC CORP.) 14 September 2006 (2006-09-14)<br>entire document | 1-20 |
| A | US 6399967 B1 (MATSUSHITA ELECTRIC INDUSTRIAL CO., LTD.) 04 June 2002 (2002-06-04)<br>entire document | 1-20 |

Form PCT/ISA/210 (second sheet) (July 2022)

## INTERNATIONAL SEARCH REPORT
### Information on patent family members

International application No.

**PCT/CN2023/108864**

| Patent document cited in search report | | | Publication date (day/month/year) | Patent family member(s) | | | Publication date (day/month/year) |
|---|---|---|---|---|---|---|---|
| CN | 115458624 | A | 09 December 2022 | CN | 115458624 | B | 24 March 2023 |
| CN | 115458623 | A | 09 December 2022 | CN | 115458623 | B | 24 March 2023 |
| JP | H05343728 | A | 24 December 1993 | | None | | |
| CN | 104576786 | A | 29 April 2015 | CN | 104576786 | B | 20 April 2016 |
| JP | 2001085729 | A | 30 March 2001 | JP | 3046970 | B1 | 29 May 2000 |
| | | | | CA | 2307745 | A1 | 15 January 2001 |
| | | | | EP | 1069626 | A2 | 17 January 2001 |
| | | | | US | 6518638 | B1 | 11 February 2003 |
| | | | | JP | 3386011 | B2 | 10 March 2003 |
| | | | | US | 2003116814 | A1 | 26 June 2003 |
| | | | | US | 6885075 | B2 | 26 April 2005 |
| CN | 105552161 | A | 04 May 2016 | CN | 105552161 | B | 29 August 2017 |
| CN | 109216495 | A | 15 January 2019 | US | 2021391490 | A1 | 16 December 2021 |
| | | | | US | 11749772 | B2 | 05 September 2023 |
| | | | | JP | 2022505735 | A | 14 January 2022 |
| | | | | WO | 2020083082 | A1 | 30 April 2020 |
| | | | | EP | 3872870 | A1 | 01 September 2021 |
| | | | | CN | 209232808 | U | 09 August 2019 |
| US | 2002158268 | A1 | 31 October 2002 | US | 6525347 | B2 | 25 February 2003 |
| | | | | US | 2003136896 | A1 | 24 July 2003 |
| | | | | US | 6909083 | B2 | 21 June 2005 |
| US | 2003151057 | A1 | 14 August 2003 | US | 6835990 | B2 | 28 December 2004 |
| | | | | JP | 2003234494 | A | 22 August 2003 |
| US | 2006202297 | A1 | 14 September 2006 | US | 2008191241 | A1 | 14 August 2008 |
| | | | | US | 7851823 | B2 | 14 December 2010 |
| | | | | JP | 2006253548 | A | 21 September 2006 |
| US | 6399967 | B1 | 04 June 2002 | US | 2002110950 | A1 | 15 August 2002 |
| | | | | US | 6627516 | B2 | 30 September 2003 |
| | | | | JP | 2001024210 | A | 26 January 2001 |
| | | | | JP | 3625258 | B2 | 02 March 2005 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 202211407177 A